# EUROPEAN PATENT SPECIFICATION

(11) **EP 0 442 490 B1**
(45) Date of publication and mention of the grant of the patent: **03.05.1995**
(21) Application number: 91102090.7
(22) Date of filing: 14.02.1991
(51) Int. Cl.: C30B 25/02, C23C 16/34, C30B 29/38, C30B 29/40

(54) **Method for producing single crystal boron nitride film**
Verfahren zur Herstellung einer einkristallinen Bornitridschicht
Procédé de fabrication de film nitrure de bore monocristallin

(30) Priority: 14.02.1990 JP 32973/90
(43) Date of publication of application: 21.08.1991
(73) Proprietor: SUMITOMO ELECTRIC INDUSTRIES, LTD., Osaka-shi, Osaka 541 (JP)
(72) Inventor: Kimoto, Tunenobu, c/o Itami Works of Sumitomo, Itami-shi, Hyogo-ken (JP); Tomikawa Tadashi, c/o Itami Works of Sumitomo, Itami-shi, Hyogo-ken (JP); Fujita, Nobuhiko, c/o Itami Works of Sumitomo, Itami-shi, Hyogo-ken (JP)
(74) Representative: Hansen, Bernd, Dr. Dipl.-Chem.

(56) References cited:
- US-A- 3 561 920
- PATENT ABSTRACTS OF JAPAN vol. 13, no. 42 (C-564)(3390) 30 January 1989,& JP-A-63 239197 (YUKIO OSAKA) 05 October 1988,
- PATENT ABSTRACTS OF JAPAN vol. 12, no. 143 (C-492)(2990) 30 April 1988,& JP-A-62 260062 (SUMITOMO ELECTRIC IND LTD) 12 November 1987,
- PATENT ABSTRACTS OF JAPAN vol. 12, no. 299 (C-520)(3146) 15 August 1988,& JP-A-63 69973 (SUMITOMO ELECTRIC IND LTD) 30 March 1988,
- JOURNAL OF CRYSTAL GROWTH. vol. 99, no. 1/4, January 1990, AMSTERDAM NL pages346 - 351; N. OHTSUKA ET AL: "A NEW GaAs ON Si STRUCTURE USING AlAs BUFFERLAYERS GROWN BY ATOMIC LAYER EPITAXY"
- JOURNAL OF CRYSTAL GROWTH. vol. 98, no. 1/2, November 1989, AMSTERDAM NL pages195 - 208; S.P. DenBAARS ET AL: "ATOMIC LAYER EPITAXY OF COMPOUNDSEMICONDUCTORS WITH METALORGANIC PRECURSORS"
- APPLIED PHYSICS LETTERS. vol. 53, no. 11, 12 September 1988, NEW YORK US pages962 - 964; O. MISHIMA ET AL: "Ultraviolet light-emitting diode of a cubic boronnitride pn junction made at high pressure"

## Description

### BACKGROUND OF THE INVENTION

### Field of the Invention

The present invention relates to a method for producing a single crystal cubic boron nitride film, which can be applied to semiconductor devices such as a diode, a transistor and a sensor, an insulating film or a cemented carbide tool.

### Description of the Related Art

Boron nitride is a compound consisting of nitrogen and boron atoms and includes various structures such as cubic boron nitride (c-BN), hexagonal boron nitride (h-BN), turbostratic boron nitride (t-BN) and amorphous boron nitride (a-BN).

h-BN has a structure in which plural hexagonal plane structure layers are piled up in the c-axis direction. t-BN has a turbulent structure of h-BN. c-BN has a zinc-blende crystal structure and is a cubic system compound. That is, at a face center position, one of the atoms is present, and the other atom is present at positions such as 1/4, 1/4, 1/4, etc.

Boron nitride is a compound similar to carbon. Roughly speaking, h-BN, a-BN and c-BN correspond to graphite, amorphous carbon and diamond, respectively. Boron nitride has similar properties to those of the corresponding carbon compound. As diamond is difficult to synthesize, among the BN compound, c-BN is most difficult to synthesize.

c-BN is expected as a material to be used in a wide variety of applications.

For example, c-BN is a promising material as a wide band gap semiconductor which can be doped to form a p-type or n-type semiconductor. More specifically, it is expected as an element of an environment resistant device, a power device or a light emitting device in a range from ultraviolet to blue by utilizing its high heat resistance, high dielectric breakdown electric field and large thermal conductivity.

Without doping, c-BN forms an insulating film having good insulating property and thermal conductivity and may be used as a layer insulation film of a device.

In addition, since c-BN has large hardness, it is promising as a tool material.

Hitherto, a c-BN single crystal has been produced only by a high pressure synthesis method. It was reported that a prototype pn-junction diode was produced from doped c-BN bulk, exhibited rectification even at a high temperature of 500°C or higher and emitted light in a range from ultraviolet to visible light at forward bias (cf. Mishima et al, Applied Physics Letters, 53 [11] 962-964 (1988)).

As described above, the presently produced c-BN crystal is a particulate crystal produced by the high pressure synthesis method. Hitherto, no c-BN film has been produced.

In view of wide application of c-BN, it is essential to produce a c-BN film.

It has been tried to produce the c-BN film by CVD methods such as thermal CVD, RF plasma CVD and microwave plasma CVD, or by PVD methods such as IVD, ion plating, activated reactive deposition and sputtering. In these methods, a raw material gas containing boron atoms and a raw material gas containing nitrogen atoms are simultaneously supplied on a substrate to synthesize boron nitride. However, none of these methods provide satisfactory results. This is because thermodynamically stable h-BN and/or a BN film having largely disturbed structure are very easily deposited.

There are may reports on the preparation of c-BN films. However, the films do not consist of the c-BN phase only. The reported BN films contain microcrystalline c-BN phases partly, and no wholly crystalline c-BN film has been prepared.

Journal of Crystal Growth, Vol. 99, Nos. 1/4, January 1990, pp. 346-351 discloses the growth of GaAs compound semiconductor layers with an AlAs layer between an Si substrate and the GaAs layer.

Journal of Crystal Growth, Vol. 98, Nos. 1/2, November 1989, pp. 195-208 reveals the growth of GaAs compound semiconductor layers onto GaAs.

### SUMMARY OF THE INVENTION

One object of the present invention is to provide a single crystal boron nitride film whole of which consists of crystalline c-BN.

Another object of the present invention is to provide a method for producing a single crystal boron nitride film whole of which consists of crystalline c-BN.

According to a first aspect of the present invention, there is provided a method for producing a single crystal cubic boron nitride film comprising alternately supplying a raw material gas comprising boron atoms and a raw material gas comprising nitrogen atoms in a vacuum chamber to form a single crystal cubic boron nitride film on a heated substrate selected from a diamond substrate and a cubic boron nitride substrate and evacuating the vacuum chamber when one raw material gas is switched to the other to prevent coexistence of both raw materials in the vacuum chamber, wherein the substrate temperature is from 300-600°C in a MBE method and from 600-1000°C in a MOCVD method.

According to a second aspect of the present invention, there is provided a method for producing a single crystal cubic boron nitride film comprising alternately supplying a raw material gas comprising boron atoms and a raw material gas comprising nitrogen atoms in a vacuum chamber to form a single crystal cubic boron nitride film on a heated substrate selected from a diamond substrate and a cubic boron nitride substrate and evacuating the vacuum chamber and purging the vacuum chamber with a gas which is inactive with the raw materials when one raw material gas is switched to the other to prevent coexistence of both raw materials in the vacuum chamber, wherein the substrate temperature is from 300-600°C in a MBE method and from 600-1000°C in a MOCVD method.

### BRIEF DESCRIPTION OF THE DRAWINGS

Fig. 1 shows an example of a c-BN film growing program according to the present invention,
Fig. 2 shows another example of a c-BN film growing program according to the present invention,
Figs. 3 and 4 are the graphs showing a relationship between the growth rate and 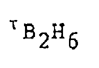 and a relationship between the growth rate and 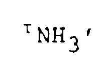 respectively in Example 1,
Fig. 5 shows a Raman spectroscopic spectrum of the c-BN film produced in Example 1,
Figs. 6 and 7 show the dependency of the growth rate on τ_{TMB} and 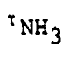 in Example 2,
Fig. 8 shows an X-ray diffraction pattern of the film which was grown on the (111) c-BN substrate in Example 2,
Fig. 9 shows a thermal decomposition type precracking apparatus,
Fig. 10 shows a PF plasma type precracking apparatus, and
Fig. 11 shows a microwave plasma type precracking apparatus,

### DETAILED DESCRIPTION OF THE DRAWINGS

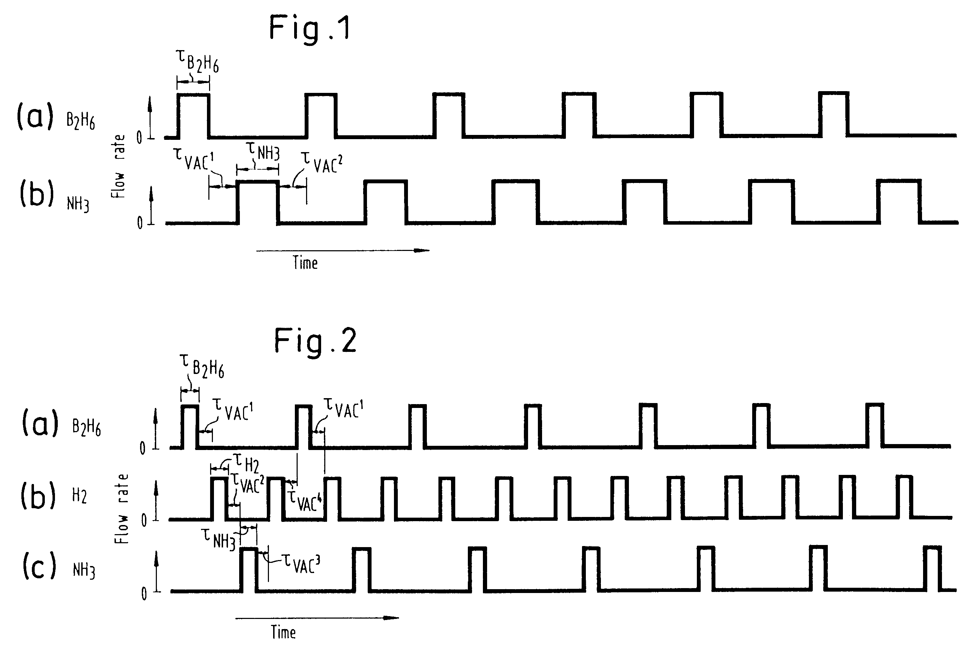

Fig. 1 shows an example of a c-BN film growing program according to the present invention, in which B₂H₆ is used as the boron-containing raw material gas, and NH₃ is used as the nitrogen-containing raw material gas. The axes of abscissa and ordinate represent a time and flow rates of the raw material gasses to be supplied in the vacuum chamber, respectively. The graphs (a) and (b) correspond to the flow rates of B₂H₆ and NH₃, respectively.

First, B₂H₆ is supplied for a certain time period 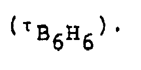
Then, the vacuum chamber is throughly evacuated for a certain time period (τ_{VAC1}). Thereafter, NH₃ is supplied for a certain time period 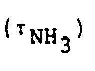
and again the vacuum chamber is evacuated for a certain time period (τ_{VAC2}). These supply of the raw material gases and evacuation procedures are repeated to produce the crystalline c-BN film. One cycle T is a sum of 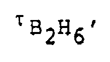
τ_{VAC1}, 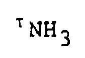
and τ_{VAC2}. Accordingly, only one raw material is present in the chamber and the both raw materials do not coexist at any moment. This is one of the characteristics of the present invention.

To further completely prevent the coexistence of the both raw materials, it is preferable to purge the vacuum chamber with a different gas when one raw material gas is switched to the other.

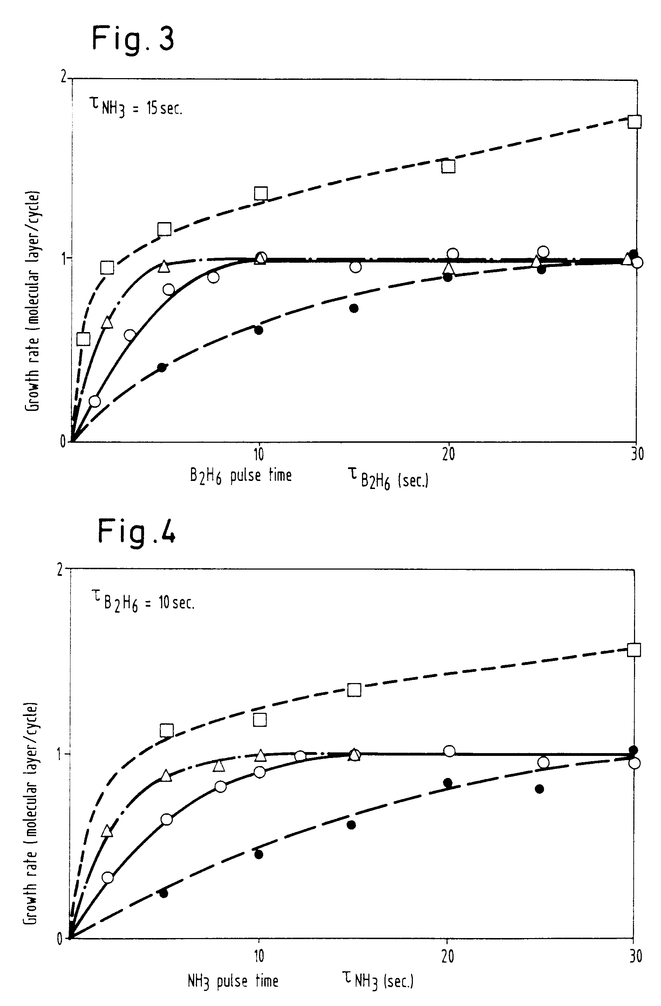

As shown in Fig. 2, after one of the raw material gasses (B₂H₆ or NH₃) is supplied in the vacuum chamber and the chamber is evacuated and before the other is supplied in the vacuum chamber, the vacuum chamber is purged with a gas which is inactive with the raw materials such as hydrogen or argon for a certain time period

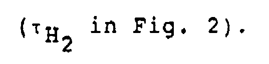

That is, first B₂H₆ is supplied for a certain time period 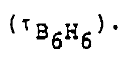
Then, the vacuum chamber is thoroughly evacuated for a certain time period (τ_{VAC1}) and a purging gas (H₂) is introduced for a certain time period 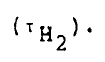
After evacuating H₂ for a certain time period (τ_{VAC2}), NH₃ is supplied for a certain time period 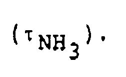
Further, the vacuum chamber is evacuated for a certain time period (τ_{VAC3}), H₂ is introduced in the vacuum chamber for a certain time period 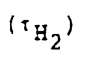
and the vacuum chamber is evacuated (τ_{VAC4}). These supply, evacuation and purging procedures are repeated to produce the crystalline c-BN film. One cycle T is a sum of 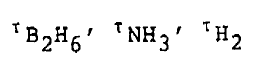
and all the evacuation time periods.

Examples of the purging gas are hydrogen, helium, argon and the like, which are inactive to the raw material gasses.

Examples of the boron-containing raw material are B₂H₆, BF₃, BCl₃, BBr₃, B(CH₃)₃, B(C₂H₅)₃, etc.

Examples of the nitrogen-containing raw material are NH₃, N₂, NF₃, etc.

These raw materials may be diluted with hydrogen, helium, argon, neon, etc.

Although each raw material gas as such can be supplied in the vacuum chamber, it may be dissociated or excited by thermal cracking, plasma or UV light before supplied on the substrate. By the dissociation or excitation, the boron or nitrogen atoms in the raw material gas are in the excited state, their reactivity is increased. Thereby, quality of the produced c-BN film is improved, and the substrate temperature can be lowered.

Therefore, a preferred embodiment of the invention is given by a method for producing a single crystal cubic boron nitride film by a MBE method comprising: pre-cracking a NH₃ gas with plasma or pyrolysis; alternately supplying a raw material NH₃ gas at a flow rate of 0.1 to 10 sccm and a raw material B₂H₆ gas at a flow rate of 0.1 to 3.0 sccm on a substrate heated at a temperature of 300°C to 600°C which is selected from the group consisting of a diamond substrate and a cubic boron nitride substrate in a vacuum chamber which is evacuated to a pressure of 7 x 10⁻⁴ Pa to 4 x 10⁻² Pa (5 x 10⁻⁶ to 3 x 10⁻⁴ Torr); and evacuating the vacuum chamber when one raw material gas is switched to the other to prevent coexistence of both raw materials in the vacuum chamber.

A further preferred embodiment of the invention is represented by a method for producing a single crystal cubic boron nitride film by a MOCVD method comprising: alternately supplying a raw material NH₃ gas at a flow rate of 2 to 1000 sccm and a raw material B(CH₃)₃ gas at a flow rate of 2 to 30 sccm on a substrate heated at a temperature of 600°C to 1000°C which is selected from the group consisting of a diamond substrate and a cubic boron nitride substrate in a vacuum chamber which is evacuated to a pressure of 13,3 Pa to 4 x 10³ Pa (0.1 to 30 Torr); and evacuating the vacuum chamber and purging the vacuum chamber interior with an inert gas when one raw material gas is switched to the other to prevent coexistence of both raw materials in the vacuum chamber.

Now, the mechanism of the present invention will be explained in comparison with the conventional method.

In the conventional vapor phase synthesis of the c-BN film, the boron-containing raw material and the nitrogen-containing raw material are simultaneously supplied on the substrate in both the CVD and PVD methods. However, the boron-containing compound and the nitrogen-containing compound have very high reactivity with each other, and a reaction product has mainly a bond with the sp² orbital. This product forms a h-BN precursor having a layer structure through the sp² bonds.

As one example, a B₂H₆-NH₃ system will be explained. B₂H₆ and NH₃ easily react each other in a temperature range between room temperature and 200°C to form various compounds such as BH₃NH₃ (borazane), (BH₂NH₂)ₓ (borazene) and B₃N₃H₆ (borazol). These compounds liberate the hydrogen atoms by heating and are converted to h-BN. Then, from these compounds, c-BN is not formed. Therefore, when the boron and nitrogen atoms coexist, h-BN with lower energy is formed.

Also, in a B₂H₆-N₂ system, h-BN is formed at a temperature higher than 1000°C or 1200°C.

h-BN may tend to be formed even when the raw materials are dissociated or excited by a plasma or a laser beam.

Under the vapor phase synthesis conditions, since h-BN is in the stable state while c-BN is in the unstable state, h-BN is deposited. Once h-BN is formed during the deposition of the BN film, it is never changed to c-BN through phase transition.

Accordingly, when the boron-containing raw material and the nitrogen-containing raw material are simultaneously supplied, the crystalline c-BN film is not produced since the precursor of h-BN is easily formed by the vapor phase reaction.

According to the present invention, the boron-containing raw material and the nitrogen-containing raw material are alternately supplied, whereby the vapor phase reaction between the two raw materials are completely prevented. Under such condition, the c-BN layer is formed layer by layer through a surface reaction of the raw materials which are adsorbed on the substrate. This layer-by-layer growth of the c-BN film will be explained below.

The substrate to be used in the method of the present invention is explained.

To produce the single crystal c-BN film, a substrate is used which has a lattice constant being the same as that of c-BN or a substrate having a lattice constant a difference of which from that of c-BN is small. Therefore, a c-BN substrate or a diamond substrate which has the lattice constant a difference of which from that of c-BN is only 1.3 % is used according to the invention.

As a plane on which the c-BN film is grown, a plane in which boron and nitrogen atoms are not present together, for example, a (100) or (111) plane or a plane which has a small off angle from the (100) or (111) plane is preferred, because the method of present invention grow layer by layer the boron layer and the nitrogen layer by supplying alternately the boron-containing raw material and the nitrogen-containing raw material.

One of the essential features of the present invention is alternate supply of the boron-containing raw material and the nitrogen-containing raw material. Since c-BN has a special property, c-BN crystal is correctly grown by such alternate supply of the raw materials. Such mechanism is called as a "self-limiting mechanism" in this invention. This mechanism will be hereinafter explained in detail.

If plural layers of the boron layers and/or the nitrogen layers are formed during the supply of the boron-containing raw material or the nitrogen-containing raw material, the c-BN film is not produced. The raw material supplied in one period should be adsorbed on the surface of the substrate or the already grown layer in one or two layers, and the film should be grown under conditions suitable for layer-by-layer growth of the film.

In case of the growth of c-BN, when one raw material gas is supplied in a specific temperature range, only one or two layers are adsorbed with respect to the specific element (B or N) contained in the supplied raw material, and further supply of the same raw material gas does not form third and subsequent layers. Namely, the growth of the layers is automatically stopped. Such property is called as the "self-limiting mechanism".

For example, when the boron-containing raw material is supplied in the absence of nitrogen atoms, boron atoms are adsorbed in only one or two layers and no additional layer of boron is adsorbed. This also applies to the nitrogen atoms.

The self-limiting mechanism is the key feature of the method of the present invention.

Conditions for achieving the self-limiting mechanism depend on kinds and supplying methods of the raw materials, a kind and plane of the substrate, growth pressure, a substrate temperature and the like. In many cases, the self-limiting mechanism works at a temperature not higher than 1200°C.

### PREFERRED EMBODIMENTS OF THE INVENTION

The present invention will be illustrated by following Examples.

### Examples

In Examples, two types of apparatuses were used, one of which was (1) an ultra-high vacuum growing (molecular beam epitaxy, MBE) apparatus and the other of which was (2) a vacuum CVD growing apparatus. These apparatuses are known ones.

Used substrate were
(i) High-pressure synthesized Ib diamond substrate (3 mm square, 0.3 mm thick), and
(ii) High-pressure synthesized undoped c-BN substrate (1.5 mm square, 0.3 mm thick).

Before setting in the apparatus, the substrates were subjected to ultrasonic cleaning in an organic solvent (e.g. isopropanol, acetone, trichloroethylene, etc.) and then treated with hydrochloric acid, hydrofluoric acid/nitric acid and aqua regia successively, followed by rinsing with ultra-pure water.

Just before supplying a raw material gas, the substrate was heated to a temperature from 1000°C to 1200°C under high vacuum of 1,3 10⁻⁶ Pa to 1,3 10⁻² Pa (10⁻⁸ to 10⁻⁴ Torr). to clean its surface.

### Example 1

### Growth of a c-BN film with the ultra-high vacuum growing apparatus (MBE)

A used apparatus was a conventional gas source MBE apparatus. In a chamber kept at ultra-high vacuum, a substrate was set with a manipulator and rotated with heating. From a molecular beam cell set below the substrate, a raw material gas was splashed towards the substrate in the form of a molecular beam. By alternately opening and closing valves, two molecular beams of the raw materials were supplied alternately. As a boron-containing raw material, B₂H₆ was used, and as a nitrogen-containing raw material, NH₃ was used.

The B₂H₆ gas is easily decomposed and polymerized at a comparatively low temperature. When it is supplied at a substrate temperature of 800 to 1000°C, a boron film is formed. That is, the self-limiting mechanism does not work. Since under such temperature condition, very precise control of the gas flow rate is required, it is difficult to grow a film with good quality. Then, when B₂H₆ is used as the raw material, a growth temperature should be not higher than 600°C.

If the substrate temperature is too low, it is difficult to decompose the nitrogen-containing raw material such as NH₃ or N₂, the nitrogen atoms are not contained in the formed film, or a crystalline film is not formed.

Thus, in this example, NH₃ was precracked with plasma before introducing in the chamber. Thereby, the nitrogen atoms are contained in the formed film even if the substrate temperature is low.

The precracking can be carried out by thermal decomposition or the plasma such as RF plasma or microwave plasma.

A precracking means is provided in the up-stream of the ultra-high vacuum growing apparatus. For example, following three precracking apparatus can be used;

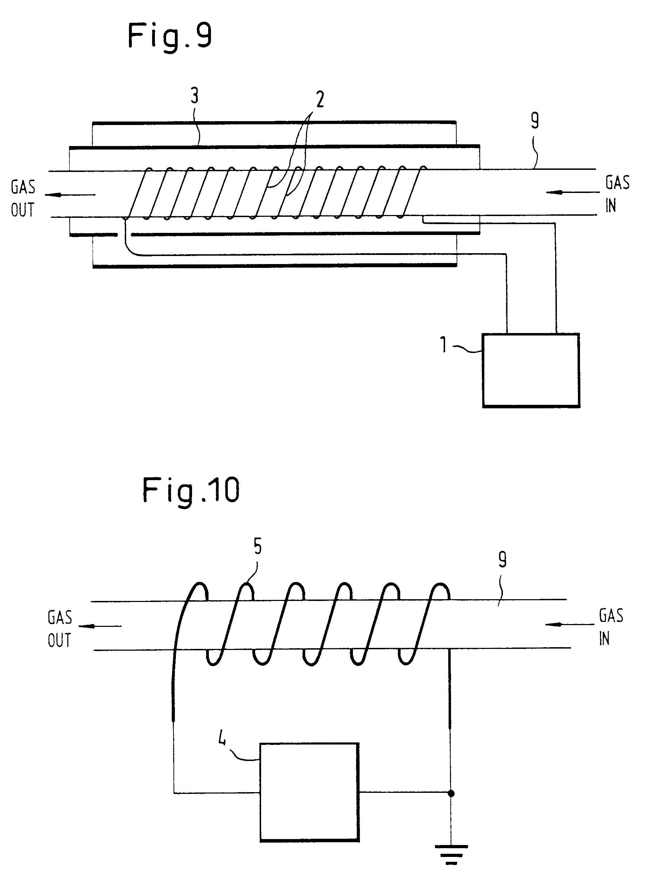

Fig. 9 shows a thermal decomposition type precracking apparatus, which comprises an insulating pipe 9 and a heater 2 wound around the pipe 9. Around the pipe 9 and the heater 2, a reflection plate 3 made of a heat resistant metal is provided. The heater 2 is powdered by a heater power source 1 and heats a part of the pipe 9 around which the heater is wound.

The raw material (NH₃) is supplied from one end (the right end in Fig. 9) of the pipe 9 and heated and precracked to form activated species. Since the material is activated, the nitrogen atoms can be dissociated even if the substrate temperature is low.

Fig. 10 shows a RF plasma type precracking apparatus, which comprises an insulating pipe 9 and an induction coil 5 wound around the pipe 9. The RF power is supplied to the induction coil 5 from a radiofrequency power source 4, and the raw material NH₃ is decomposed with the RF power to form activated species.

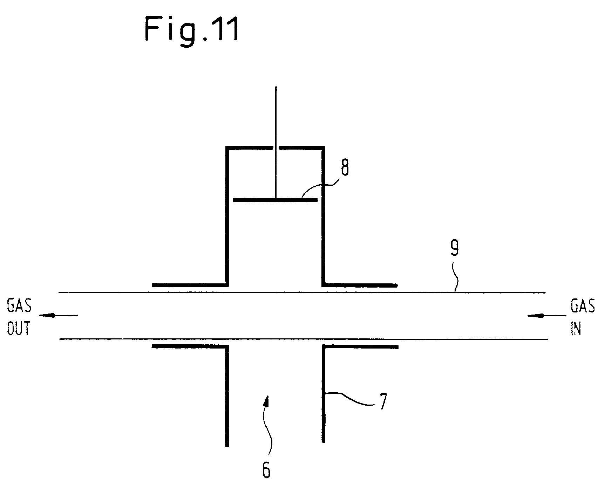

Fig. 11 shows a microwave plasma type precracking apparatus, which comprises a waveguide tube 7 and a variable short-circuit plate 8. The insulating pipe 9 passes through a part of the waveguide tube 7. When the raw material NH₃ flows through the insulating pipe 9, it is decomposed with microwave.

In this Example, the apparatus of Fig. 11 was used, and NH₃ was precracked with the microwave plasma (2.45 GHz) and introduced in the growing apparatus to grow the c-BN film.

The growing conditions were as follows:
- Flow rates:: B₂H₆ = 0.1 to 3.0 sccm
NH₃ = 0.1 to 10 sccm.
- Back pressure:: 2,7 x 10⁻⁸ Pa (2 x 10⁻¹⁰ Torr).
- Growing pressure:: 7 x 10⁻⁴ Pa to 4 x 10⁻² Pa (5 x 10⁻⁶ to 3 x 10⁻⁴ Torr).
- Substrate temperature:: 300 to 800°C.
- Microwave power for precracking :: 150 W
- Substrate:: Ultra-high pressure synthesized diamond Ib with the (100) plane.

First, the self-limiting mechanism was studied.

At the flow rates of 0.5 sccm and 1.5 sccm of B₂H₆ and NH₃, respectively, a film was formed according to the growth program of Fig. 1.

As described above, between each supply periods of B₂H₆ and NH₃, the chamber was evacuated to prevent the mixing of the two raw materials. Dependency of a growing rate on 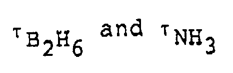
was examined with varying

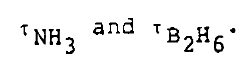

The results are shown in Figs. 3 and 4, which are the graphs showing a relationship between the growth rate and 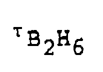
and a relationship between the growth rate and 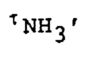
respectively.

Here, the growth rate means a film thickness grown in one cycle of gas flow pulse. when each one layer of boron and nitrogen of the c-BN layer is grown, the growth rate is one (one molecular layer/cycle). With this factor, the growth rates were normalized.

In Figs. 3 and 4, the black circles are the results at the substrate temperature of 300°C, the white circles are the results at 400°C, the triangles are the results at 600°C, and the squares are the results at 800°C.

As seen from Fig. 3, at the substrate temperature of from 300 to 600°C, the growth rate increases in proportional with 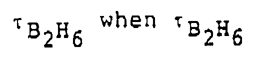
is small, but saturates at a certain value of 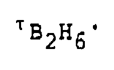
The saturated growth rate is one (1). In this substrate temperature range, the growth rate saturates at a single molecular layer and the thickness does not increase. That is, a layer consisting of boron does not grow.

At 800°C, the growth rate does not saturate and increases as 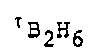
increases. This means that the boron layer continues to grow.

The above applies to NH₃. As seen from Fig. 4, at the substrate temperature of from 300 to 600°C, the growth rate increases as 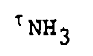
increases, but it saturates when 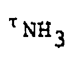
is from several seconds to about 30 seconds. The saturated growth rate is one (1). At the substrate temperature of 800°C or higher, the growth rate does not saturate.

Even when 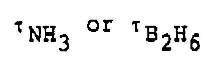
is increased, the film thickness per one pulse saturates and does not exceed a certain value. This means that, even if the supply amount of the raw material is increased, the growth stops at a single atom layer which is adsorbed on the substrate surface or the previously formed layer.

When the substrate temperature is 800°C, the growth rate gradually increases as 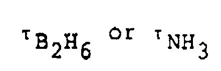
increases. This means that, at 800°C, the self-limiting mechanism does not work perfectly. At such high substrate temperature, it is difficult to grow the boron atoms or the nitrogen atoms layer by layer.

Under the conditions under which the self-limiting mechanism works, The boron layer and the nitrogen layer can be alternately grown layer by layer. Thus, under such conditions, the film growth can be carried out with excellent control.

All of the films grown under such conditions were the single crystal c-BN films.

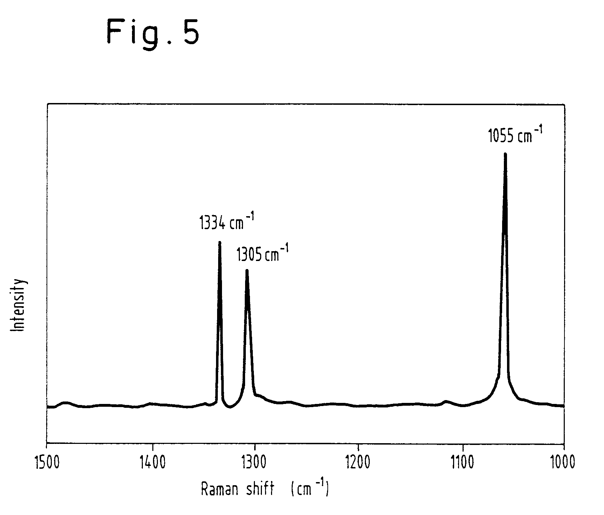

As an example, a c-BN film of a thickness of about 1 »m was grown on a diamond substrate at 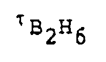
of 10 sec., 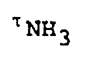
of 15 sec. and a substrate temperature of 400°C. The Raman spectroscopic spectrum of the produced c-BN film is shown in Fig. 5. The sharp Raman shift peaks of c-BN are observed at 1055 cm⁻¹ and 1305 cm⁻¹. The peak at 1334 cm⁻¹ is assigned to the diamond of the substrate.

According to evaluation by RHEED, the spot pattern corresponding to c-BN (100) was obtained. This means that the grown film was the single crystal of c-BN (100).

In addition, the X-ray diffraction analysis confirmed the growth of c-BN (100).

Though the self-limiting mechanism does not work perfectly at the high substrate temperature, for instance, 800°C in the above Examples, it is possible to grow the c-BN film by precisely controlling the supply of the raw materials. That is, the c-BN can be formed by selecting 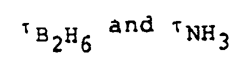
so that the growth rate is one molecular layer per cycle.

The conditions which achieve the self-limiting mechanism depend on the kinds and flow rates of the raw materials, the growth pressure, the kind and temperature of the substrate and the like. For example, when BCl₃ is used as a boron-containing raw material or when N₂ is used as a nitrogen-containing raw material, a higher substrate temperature is required than the B₂H₆-NH₃ system.

### Example 2

### Growth of a c-BN film with the vacuum CVD growing apparatus (MOCVD)

A used apparatus was a conventional vacuum thermal CVD apparatus. In this apparatus, the raw material is flowed in a gas state without forming the molecular beam as in the MBE, and the pressure is higher than in the case of MBE. The substrate is set with facing upward or sideward. As a boron-containing raw material, trimethylboron [B(CH₃)₃] (TMB) was used, and as a nitrogen-containing raw material, NH₃ was used. The growing conditions were as follows:
- Flow rates:: TMB: 2 to 30 sccm.
MH₃: 2 to 100 sccm.
- Pressure: 13,3 Pa to 4 x 10³ Pa: (0.1 to 30 Torr).
- Substrate temperature:: 300 to 1300°C.
- Substrates:: High pressure synthesized diamond 1b (111) or
High pressure synthesized c-BN (111).

The film was grown according to the growth program of Fig. 2. Namely, the chamber was purged by supplying the hydrogen (H₂) gas at a flow rate of 5 to 30 sccm between the supply periods of TMB and NH₃.

In the same procedures as in Example 1, the self-limiting mechanism was studied.

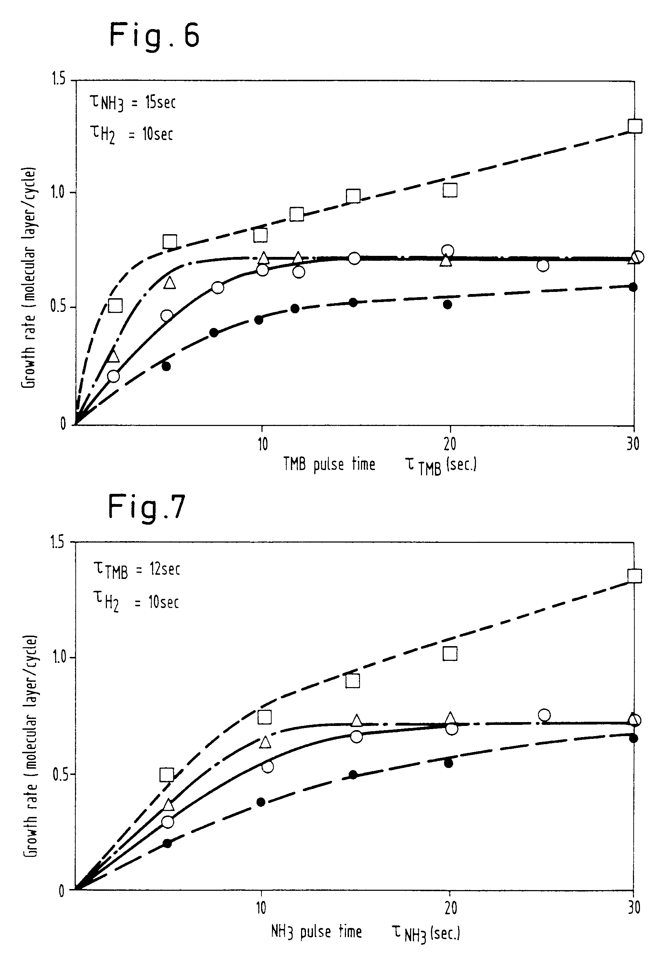

Figs. 6 and 7 show the dependency of the growth rate on τ_{TMB} and 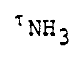
when the flow rates of TMB, NH₃ and H₂ were 3 sccm., 15 sccm. and 20 sccm., respectively and the length of the H₂ gas pulse was 10 sec. There was no material difference of the results in Figs. 6 and 7 between the diamond substrate and the c-BN substrate.

As seen from the results of Figs. 6 and 7, the complete saturation of the growth rate was observed in the temperature range between 600°C and 1000°C in relation to τ_{TMB} and 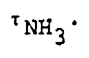
This means that the self-limiting mechanism worked.

The condition range in which the self-limiting mechanism works in this example was slightly different from those in Example 1. That is, in this example, up to about 1000°C of the substrate temperature, the self-limiting mechanism worked, but at a substrate temperature of 1200°C or higher, the self-limiting mechanism did not work. Such difference is based on the differences of the apparatuses and the raw materials.

The content of "self-limiting" is also different. The growth rate at which the self-limiting mechanism worked was 0.6 to 0.8 molecular layer per cycle, which was different from the one molecular layer per cycle in Example 1. The reason for this difference is as follow:

Since TMB has three bulky methyl groups, when one molecule is adsorbed on the substrate surface, it interferes adjacent adsorbing sites. The growth rate at which the self-limiting mechanism works, namely the film thickness which is obtained in one gas pulse varies with the raw material gases, the kind of the substrate, and the like.

The produced film was evaluated by IR spectroscopy, Raman spectroscopy, X-ray diffraction and RHEED to find that the film produced under the self-limiting conditions was a single crystal c-BN film.

Both on the (111) diamond substrate and the (111) c-BN substrate, the single crystal (111) c-BN grew epitaxially.

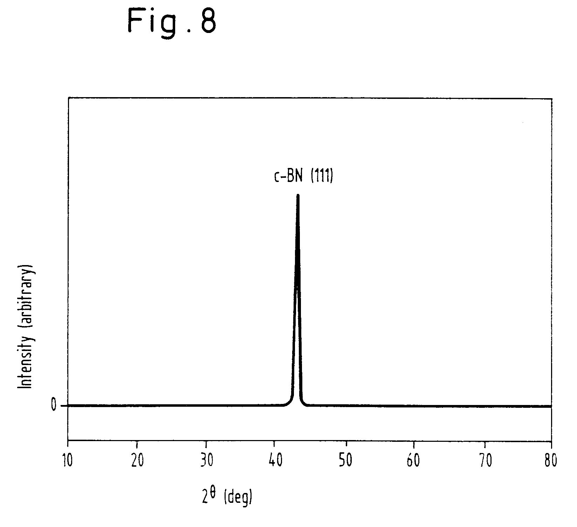

For example, Fig. 8 shows an X-ray diffraction pattern of the film which was grown on the (111) c-BN substrate at τ_{TMB} of 12 sccm, 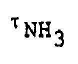
of 15 sccm and the substrate temperature of 1000°C and had a thickness of about 1.5 »m.

At 2ϑ of 43.3°, a sharp peak assigned to the (111) plane of c-BN was observed. There was no peak to be assigned to the (200) or (220) plane of c-BN.

In the RHEED, a spot pattern of the (111) plane of c-BN was obtained.

From these results, the grown film was a single crystal film of c-BN (111).

Even if the substrate temperature is high so that the self-limiting mechanism does not work, the precise control of the flow rates of the raw material gases makes it possible to grow the c-BN film as in Example 1.

When triethylboron [B(C₂H₅)₃] or boron fluoride (BF₃) is used in place of TMB, the c-BN film can be formed.

## Claims

1. A method for producing a single crystal cubic boron nitride film comprising:
alternately supplying a raw material gas comprising boron atoms and a raw material gas comprising nitrogen atoms in a vacuum chamber to form a single crystal cubic boron nitride film on a heated substrate selected from a diamond substrate and a cubic boron nitride substrate; and
evacuating the vacuum chamber when one raw material gas is switched to the other to prevent coexistence of both raw material gases in the vacuum chamber, wherein the substrate temperature is from 300 to 600°C in a Molecular Beam Epitaxy (MBE) method or 600 to 1000°C in a Metal Organic Chemical Vapour Deposition (MOCVD) method.

2. The method according to claim 1, wherein the raw material comprising the boron atoms is selected from the group consisting of B₂H₆, BF₃, BCl₃, BBr₃, B(CH₃)₃ and B(C₂H₅)₃.

3. The method according to claim 1, wherein the raw material comprising the nitrogen atoms is selected from the group consisting of NH₃, N₂ and NF₃.

4. A method for producing a single crystal cubic boron nitride film comprising:
alternately supplying a raw material gas comprising boron atoms and a raw material gas comprising nitrogen atoms in a vacuum chamber to form a single crystal cubic boron nitride film on a heated substrate selected from a diamond substrate and a cubic boron nitride substrate; and
evacuating the vacuum chamber and purging the vacuum chamber with a gas which is inactive with the raw material gases when one raw material gas is switched to the other to prevent coexistence of both raw material gases in the vacuum chamber, wherein the substrate temperature is from 300 to 600°C in a MBE method or 600 to 1000°C in a MOCVD method.

5. The method according to claim 4, wherein the raw material comprising the boron atoms is selected from the group consisting of B₂H₆, BF₃, BCl₃, BBr₃, B(CH₃)₃ and B(C₂H₅)₃.

6. The method according to claim 4, wherein the raw material comprising the nitrogen atoms is selected from the group consisting of NH₃, N₂ and NF₃.

7. The method according to claim 4, wherein a purging gas is hydrogen or argon.

8. A method for producing a single crystal cubic boron nitride film by a MBE method comprising:
pre-cracking a NH₃ gas with plasma or pyrolysis;
alternately supplying a raw material NH₃ gas at a flow rate of 0.1 to 10 sccm and a raw material B₂H₆ gas at a flow rate of 0.1 to 3.0 sccm on a substrate heated at a temperature of 300°C to 600°C which is selected from the group consisting of a diamond substrate and a cubic boron nitride substrate in a vacuum chamber which is evacuated to a pressure of 7 x 10⁻⁴ Pa to 4 x 10⁻² Pa (5 x 10⁻⁶ to 3 x 10⁻⁴ Torr); and
evacuating the vacuum chamber when one raw material gas is switched to the other to prevent coexistence of both raw materials in the vacuum chamber.

9. A method for producing a single crystal cubic boron nitride film by a MOCVD method comprising:
alternately supplying a raw material NH₃ gas at a flow rate of 2 to 1000 sccm and a raw material B(CH₃)₃ gas at a flow rate of 2 to 30 sccm on a substrate heated at a temperature of 600°C to 1000°C which is selected from the group consisting of a diamond substrate and a cubic boron nitride substrate in a vacuum chamber which is evacuated to a pressure of 13,3 Pa to 4 x 10³ Pa (0.1 to 30 Torr); and
evacuating the vacuum chamber and purging the vacuum chamber interior with an inert gas when one raw material gas is switched to the other to prevent coexistence of both raw materials in the vacuum chamber.

## Patentansprüche

1. Verfahren zur Herstellung eines Einkristall-kubischen Bornitridfilms, umfassend:
die alternative Zufuhr eines Rohmaterialsgases, umfassend Boratome und eines Rohmaterialgases, umfassend Stickstoffatome in eine Vakuumkammer zur Ausbildung eines Einkristall-kubischen Bornitridfilms auf einem erhitzten Substrat, ausgewählt aus einem Diamantsubstrat und einem kubischen Bornitridsubstrat; und
Evakuieren der Vakuumkammer, wenn ein Rohmaterialgas zu dem anderen verändert wird, um das Koexistieren der beiden Rohmaterialgase in der Vakuumkammer zu vermeiden, wobei die Substrattemperatur von 300 bis 600°C bei einer Molekular-Beam-Epitaxy (MBE)-Methode beträgt, oder 600 bis 1000°C bei einer metallorganischen chemischen Dampfabscheidungsmethode (MOCVD).

2. Verfahren gemäß Anspruch 1, bei dem das Rohmaterial, umfassend Boratome, ausgewählt ist aus der Gruppe, bestehend aus B₂H₆, BF₃, BCl₃, BBr₃, B(CH₃)₃ und B(C₂H₅)₃.

3. Verfahren gemäß Anspruch 1, bei dem das Rohmaterial, umfassend Stickstoffatome, ausgewählt ist aus der Gruppe, betehend aus NH₃, N₂ und NF₃.

4. Verfahren zur Herstellung eines Einkristall-kubischen Bornitridfilm, umfassend
das alternative Zuführen eines Rohmaterialgases, umfassend Boratome, und eines Rohmaterialgases, umfassend Stickstoffatome, in eine Vakuumkammer unter Ausbildung eines Einkristall-kubischen Bornitridfilms auf einem erhitzten Substrat, ausgewählt aus einem Diamantsubstrat und einem kubischen Bornitridsubstrat; und
Evakuieren der Vakuumkammer und Spülen der Vakuumkammer mit einem Gas, das gegenüber den Rohmaterialgasen inaktiv ist, wenn ein Rohmaterialgas durch das andere verändert wird, um ein Koexistieren der beiden Rohmaterialgase in der Vakuumkammer zu verhindern, wobei die Substrattemperatur 300 bis 600°C bei einer MBE-Methode oder 600 bis 1000°C bei einer MOCVD-Methode ist.

5. Verfahren gemäß Anspruch 4, bei dem das Rohmaterial, umfassend Boratome, ausgewählt ist aus der Gruppe, bestehend aus B₂H₆, BF₃, BCl₃, BBr₃, B(CH₃)₃ und B(C₂H₅)₃.

6. Verfahren gemäß Anspruch 4, bei dem das Rohmaterial, umfassend die Stickstoffatome, ausgewählt ist aus der Gruppe, bestehend aus NH₃, N₂ und NF₃.

7. Verfahren gemäß Anspruch 4, bei dem das Spülgas Wasserstoff oder Argon ist.

8. Verfahren zur Herstellung eines Einkristall-kubischen Bornitridfilms mittels einer MBE-Methode, umfassend:
Vorspalten eines NH₃-Gases durch Plasma oder Pyrolyse;
alternatives Zuführen eines Rohmaterial-NH₃-Gases mit einer Fließrate von 0,1 bis 10 sccm und eines Rohmaterial-B₂H₆-Gases mit einer Fließrate von 0,1 bis 3,0 sccm auf ein Substrat, das auf eine Temperatur von 300°C bis 600°C erhitzt ist, ausgewählt aus der Gruppe, bestehend aus einem Diamantsubstrat und einem kubischen Bornitridsubstrat in einer Vakuumkammer, die auf einen Druck von 7 x 10⁻⁴ Pa bis 4 x 10⁻² Pa (5 x 10⁻⁶ bis 3 x 10⁻⁴ Torr) evakuiert ist, und
Evakuieren der Vakuumkammer, wenn man von einem Rohmaterialgas auf das andere Rohmaterialsgas schaltet, um eine Koexistenz der beiden Rohmaterialien in der Vakuumkammer zu verhindern.

9. Verfahren zur Herstellung eines Einkristall-kubischen Bornitridfilms mittels einer MOCVD-Methode,
umfassend
das alternative Zuführen eines Rohmaterial-NH₃-Gases mit einer Fließrate von 2 bis 1000 sccm und eines Rohmaterial-B(CH₃)₃-Gases mit einer Fließrate von 2 bis 30 sccm zu einem Sustrat, das auf eine Temperatur von 600°C bis 1000°C erhitzt ist, und welches ausgewählt ist aus der Gruppe, bestehend aus einem Diamantsubstrat und einem kubischen Bornitridsubstrat in einer Vakuumkammer, die auf einen Druck von 13,3 Pa bis 4 x 10³ Pa (0,1 bis 30 Torr) evakuiert ist, und
Evakuieren der Vakuumkammer und Spülen des Inneren der Vakuumkammer mit einem Inertgas, wenn man von einem Rohmaterialgas zu dem anderen schaltet, um eine Koexistenz der beiden Rohmaterialien in der Vakuumkammer zu verhindern.

## Revendications

1. Procédé pour produire un film de nitrure de bore cubique monocristallin consistant :
à introduire alternativement un gaz de matériau brut comprenant des atomes de bore et un gaz de matériau brut comprenant des atomes d'azote dans une chambre à vide pour former un film de nitrure de bore cubique monocristallin sur un substrat chauffé choisi parmi un substrat de diamant et un substrat de nitrure de bore cubique ; et
à faire le vide dans la chambre à vide lorsqu'on passe d'un gaz de matériau brut à l'autre pour éviter une coexistance des deux gaz de matériaux bruts dans la chambre à vide, dans lequel la température du substrat est de 300 à 600°C dans un procédé d'épitaxie par faisceau moléculaire (MBE) et de 600 à 1000°C dans un procédé de déposition en phase vapeur de produit chimique métalloorganique (MOCVD).

2. Procédé selon la revendication 1, dans lequel le matériau brut comprenant les atomes de bore est choisi dans le groupe constitué de B₂H₆, BF₃, BCl₃, BBr₃, B(CH₃)₃ et B(C₂H₅)₃.

3. Procédé selon la revendication 1, dans lequel le matériau brut comprenant les atomes d'azote est choisi dans le groupe constitué de NH₃, N₂ et NF₃.

4. Procédé pour produire un film de nitrure de bore cubique monocristallin consistant :
à introduire alternativement un gaz de matériau brut comprenant des atomes de bore et un gaz de matériau brut comprenant des atomes d'azote dans une chambre à vide pour former un film de nitrure de bore cubique monocristallin sur un substrat chauffé choisi parmi un substrat de diamant et un substrat de nitrure de bore cubique ; et
à faire le vide dans la chambre à vide et à purger la chambre à vide avec un gaz qui est inactif avec les gaz de matériaux bruts lorsqu'on passe d'un gaz de matériau brut à l'autre pour éviter une coexistance des deux gaz de matériaux bruts dans la chambre à vide, dans lequel la température du substrat est de 300 à 600°C dans un procédé MBE ou de 600 à 1000°C dans un procédé MOCVD.

5. Procédé selon la revendication 4, dans lequel le matériau brut comprenant les atomes de bore est choisi dans le groupe constitué de B₂H₆, BF₃, BCl₃, BBr₃, B(CH₃)₃ et B(C₂H₅)₃.

6. Procédé selon la revendication 4, dans lequel le matériau brut comprenant les atomes d'azote est choisi dans le groupe constitué de NH₃, N₂ et NF₃.

7. Procédé selon la revendication 4, dans lequel un gaz de purge est l'hydrogène ou l'argon.

8. Procédé pour produire un film de nitrure de bore cubique monocristallin par un procédé MBE consistant :
à pré-craquer un gaz de NH₃ avec un plasma ou une pyrolyse ;
à introduire alternativement un gaz de NH₃ de matériau brut à un débit de 0,1 à 10 Ncm³/min et un gaz de B₂H₆ de matériau brut à un débit de 0,1 à 3,0 Ncm³/min sur un substrat chauffé à une température de 300°C à 600°C qui est choisi dans le groupe constitué d'un substrat de diamant et d'un substrat de nitrure de bore cubique dans une chambre à vide dans laquelle on a fait le vide à une pression de 7 x 10⁻⁴ Pa à 4 x 10⁻² Pa (5 x 10⁻⁶ à 3 x 10⁻⁴ Torr) ; et
à faire le vide dans la chambre à vide lorsqu'on passe d'un gaz de matériau brut à l'autre pour éviter une coexistance des deux matériaux bruts dans la chambre à vide.

9. Procédé pour produire un film de nitrure de bore cubique monocristallin par un procédé MOCVD consistant :
à introduire alternativement un gaz de NH₃ de matériau brut à un débit de 2 à 1000 Ncm³/min et un gaz de B(CH₃)₃ de matériau brut à un débit de 2 à 30 Ncm³/min sur un substrat chauffé à une température de 600°C à 1000°C qui est choisi dans le groupe constitué d'un substrat de diamant et d'un substrat de nitrure de bore cubique dans une chambre à vide dans laquelle on a fait le vide à une pression de 13,3 Pa à 4 x 10³ Pa (0,1 à 30 Torr) ; et
à faire le vide dans la chambre à vide et à purger l'intérieur de la chambre à vide avec un gaz inerte lorsqu'on passe d'un gaz de matériau brut à l'autre pour éviter une coexistance des deux matériaux bruts dans la chambre à vide.
